# EUROPÄISCHE PATENTSCHRIFT

(11) **EP 1 657 594 B1**
(45) Veröffentlichungstag und Bekanntmachung des Hinweises auf die Patenterteilung: **03.10.2007**
(21) Anmeldenummer: 05024471.4
(22) Anmeldetag: 09.11.2005
(51) Int. Cl.: G03F 7/42, G03F 7/12, B41N 3/00, B41M 1/12

(54) **Verfahren zur Hydrophilierung von Siebruckschablonenträgern sowie Verfahren zur Entfernung von Schablonenmaterial von einem Siebdruckschablonenträger und Entschichtungsflüssigkeit hierfür**
Hydrophilization process for a screen printing carrier, process and liquid for removing screen material from the carrier
Procédé de hydrophilisation d'un support pour l'impression par sérigraphie, procédé et liquide pour enlever le matériau de l'écran de sérigraphie

(30) Priorität: 15.11.2004 DE 102004055113
(43) Veröffentlichungstag der Anmeldung: 17.05.2006
(73) Patentinhaber: Kissel & Wolf GmbH, D-69168 Wiesloch (DE)
(72) Erfinder: Wittemann, Günter, 69234 Dielheim (DE)
(74) Vertreter: Paul, Dieter-Alfred

(56) Entgegenhaltungen:
- DE-A1- 1 817 416
- DE-A1- 2 302 224
- DE-A1- 2 364 037
- DE-A1- 2 725 499
- DE-A1- 3 117 358
- DE-A1- 10 116 200
- US-A1- 2002 005 130

## Beschreibung

Die Erfindung bezieht sich auf ein verfahren zur Hydrophilierung von Siebdruckschablonenträgern, bei denen der Siebdruckschablonenträger vor dem Aufbringen von Schablonenmaterial mit einem Hydrophilierungsmittel behandelt wird. Sie bezieht sich des weiteren auf ein Verfahren zur Entfernung von Schablonenmaterial von einem Siebdruckschablonenträger, in dem auf den Siebdruckschablonenträger bzw. das Schablonenmaterial eine Entschichtungsflüssigkeit aufgebracht wird, die ein Entschichtungsmittel und ein Benetzungsmittel enthält. Schließlich betrifft die Erfindung eine Entschichtungsflüssigkeit zum Entfernen von Schablonenmaterial von einem Schablonenträger.

Zur Herstellung einer Siebdruckform wird ein Siebdruckschablonenträger - meist in Form eines Siebdruckgewebes - mit einem gegenüber UV-Licht empfindlichen, wasserlöslichen Schablonenmaterial - auch Kopiermaterial genannt - beschichtet. Nach dem Trocknen wird der Teil des Schablonenmaterials, der den Siebdruckschablonenträger dauerhaft verschließen soll, mittels beispielsweise eines Diapositivs mit UV-Licht bestrahlt. Hierdurch vernetzt das Schablonenmaterial in dem Bereich, in dem es mit UV-Licht beaufschlagt wird, und wird wasserunlöslich. Die von dem UV-Licht nicht belichteten Bereiche bleiben wasserlöslich und werden nach dem Belichtungsprozeß ausgewaschen, so daß der Siebdruckschablonenträger in diesen Bereichen für die Druckfarbe durchlässig ist. Das Ergebnis ist eine Siebdruckschablone.

Übliches Schablonenmaterial besteht im wesentlichen aus einem wasserlöslich Basispolymer, homo- oder copolymeren Dispersionen, Weichmachern sowie Harzen und Additiven. Der Hauptbestandteil ist Wasser. Da Siebdruckschablonenträger in der Regel aus Kunststoffgeweben bestehen, sind sie hydrophob. Dies macht Schwierigkeiten bei der Benetzung des Siebdruckschablonenträgers mit dem wässrigen Schablonenmaterial, so daß es zu die Qualität des Drukkergebnisses beeinträchtigenden Fehlstellen kommt.

Zur vermeidung dieses Problems wird der Siebdruckschablonenträger vor dem Auftrag des Schablonenmaterials mit einem Entfettungsmittel, bestehend im wesentlichen aus einem nichtionischen Tensid und Wasser behandelt. Hierdurch wird jedoch kein ausreichend dauerhafter Hydrophilierungseffekt erzielt. Auch die Wirksamkeit der Hydrophilierung ist gering.

Des weiteren ist es bekannt, Schablonenmaterial von einem Siebdruckschablonenträger mittels einer Entschichtungsflüssigkeit zu entfernen, die ein Benutzungsmittel in Form eines oberflächenaktiven Mittels, beispielsweise ein nichtionisches Tensid, enthält (vgl. DE-A-2 302 224 und DE-A-27 25 499). Auf diese Weise tritt eine gewisse Hydrophilisierung beim Entfernen des Schablonenmaterials ein. Die Wirksamkeit der Hydrophilisierung ist jedoch ebenfalls begrenzt.

Zur Hydrophilisierung von lithographischen Druckplatten ist es bekannt, auf die Druckplatte eine im Mikrometerbereich liegende Beschichtung, bestehend aus einem Bindermaterial und feinstteiligen Oxidteilchen, aufzubringen. Die Oxidteilchen setzen sich aus weniger als 30 Gew.-% Aluminiumoxid und mehr als 40% Titanoxid zusammen (vgl. US 2002/0005130 A1).

In der DE 31 17 358 A1 ist ein Verfahren zum Reinigen und Rehydrophilieren von Offset-Druckformen bekannt, bei dem das Reinigungsmittel ein Silikat, Wasser, ein Dispergierhilfsmittel und/oder eine davon verschiedene oberflächenaktive Verbindung sowie zumindest ein organisches Lösemittel enthält. Mit diesem Reinigungs- und Hydrophilierungsmittel sollen Korrekturstellen vor Beginn des Druckvorgangs hydrophiliert, als auch bereits tonende Stellen von Nichtbildstellen der Offset-Druckformen gereinigt und rehydrophiliert werden. Die beim Druck bildführenden Teile der Druckformen sollen durch das Mittel nicht angegriffen werden.

Der Erfindung liegt zum einen die Aufgabe zugrunde, Verfahren bereitzustellen, mit denen sich eine wirksam Hydrophilierung eines Siebdruckschablonenträgers erzielen und durch deren Anwendung sich die Benetzung des Siebdruckschablonenträgers mit Schablonenmaterial wesentlich verbessern läßt. Zum anderen besteht die Aufgabe darin, ein hierfür geeignetes Mittel bereitzustellen.

Der erste Teil der Aufgabe wird erfindungsgemäß durch ein Verfahren gelöst, bei dem ein Hydrophilierungsmittel verwendet wird, das feinstteilige Aluminium- und/oder Zirkonium-Oxidteilchen mit einer im Nanobereich liegenden Teilchengröße und ein Benetzungsmittel enthält. Bei Anwendung dieses Hydrophilierungsmittels vor Aufbringen von Schablonenmaterial auf den Siebdruckschablonenträger wird letzterer außerordentlich wirksam und dauerhaft hydrophiliert mit der Folge, daß der Siebdruckschablonenträger von dem Schablonenmaterial wesentlich besser, als mit den Mitteln des Standes der Technik, benetzt wird und visuell erkennbare Fehlstellen kaum noch vorkommen oder vollständig fehlen.

Aufgrund der DE 101 16 200 A1 ist es bekannt, Oberflächen wie Glas, Kunststoff, Metall und Keramik mit einer hydrophilen Beschichtungszusammensetzung zu versehen, die feinstteilige Oxidteilchen und einen Oberflächenmodifikator aufweisen. Hierdurch soll bewirkt werden, daß sich feine Wassertröpfchen, wie sie sich zum Beispiel durch Taueffekte niederschlagen, zu einem geschlossenen Film zusammenlaufen, so daß sie optisch nicht mehr stören (Antibeschlageffekt). Außerdem soll die Trocknung benetzter Oberflächen begünstigt und eine Antischmutzwirkung erzielt werden. Als Einsatzfälle werden die Behandlung von Spiegeln, Wärmetauscher, Bekleidungsstücke, wasserlose Urinale und Verbände, windeln sowie Papier und Zellstoff genannt.

In Ausbildung der Erfindung ist vorgesehen, daß die Oxidteilchen eine zwischen 2 bis 100 nm, vorzugsweise 2 bis 40 nm, liegende Teilchengröße haben. Die Oxidteilchen können mit Ionen aus der Gruppe der Alkali- bzw. Erdalkaliionen und/oder mit anorganischen oder organischen Salzen modifiziert sein, welche in Verbindung mit Aluminium, Zirkonium, Zink oder Titan vorliegen. Alternativ dazu oder in Kombination damit können die Oxidteilchen auch dadurch funktionalisiert sein, daß funktionelle Gruppen der organischen Seitenketten Epoxid-, Acryloxy-, Methacryloxy-, Glycidiloxy-, Alkyl-, vinyl-, Carboxyl-, Mercapto-, Hydrooxyl-, Amid-, Amino-, Isocyano- oder Silanolgruppen eingefügt sind. Der Anteil der Oxidteilchen in dem Hydrophilierungsmittel sollte zwischen wenigstens 0,15 und höchstens 29,7 Gew.% liegen.

Das erfindungsgemäße ebenfalls vorhandene Benetzungsmittel ist zweckmäßigerweise ein Tensid, insbesondere ein nichtionisches Tensid. Als nichtionisches Tensid kommt ein Ethoxylat oder Alkoxylat von primären und sekundären Fettalkoholen oder von Alkylphenolen, ein Ethylenoxid/Propylenoxid- oder Propylenoxid/Ethylenoxid-Blockpolimerisat, ein Aminethoxylat, Aminalkoxylat, ein Alkylpolyglycolid, ein Fettaminoxid, ein Fettsäurealkanolamid und/oder ein Fettsäurealkylglucamid in Frage. Das Benetzungsmittel sollte in dem Hydrophilierungsmittel mit einem Gehalt von 0.01 bis 20 Gew.*%* vorhanden sein. Der jeweilige Rest ist zweckmäßigerweise Wasser.

Alternativ zu dem zuvor beschriebenen Verfahren kann eine Hydrophilierung des Siebdruckschablonenträgers auch dadurch erfolgen, daß das vorbeschriebene, erfindungsgemäße Hydrophilierungsmittel bei der Entfernung von Schablonenmaterial von dem Siebdruckschablonenträger in der Form eingesetzt wird, daß es der ein Entschichtungsmittel enthaltenen Entschichtungsflüssigkeit zugegeben wird. Bei der Entschichtung des Siebdruckschablonenträgers zwecks Herstellung einer neuen Siebdruckschablone wird der Siebdruckschablonenträger nicht nur von dem Schablonenmaterial befreit, sondern gleichzeitig auch für den nächsten Beschichtungsvorgang hydrophiliert, und zwar wesentlich wirksamer als mit den bekannten Entfettungsmitteln. Eines besonderen Hydrophilierungsschrittes bedarf es dann nicht. Im unterschied zu dem erstgenannten verfahren sollte dabei das Benetzungsmittel mit einem Gehalt von mindestens 0,01 bis höchstens 20 Gew.% vorhanden sein.

Das Entschichtungsmittel enthält in an sich bekannter weise ein Oxidationsmittel, wobei hier insbesondere ein Jodat, insbesondere Periodat und/oder eine Periodsäure, vorzugsweise ein Natriummetaperiodat, in Frage kommen. Entsprechende Zusammensetzungen ergeben sich beispielsweise aus der DE-A-27 25 499 und der DE 200 22 468 U1. Das Oxidationsmittel sollte in der Entschichtungsflüssigkeit mit einem Gehalt von mindestens 0,1 und höchstens 5 Gew.% vorhanden sein.

Die Entschichtungsflüssigkeit kann zusätzlich auch ein organisches Lösungsmittel, vorzugsweise ausgewählt aus der Gruppe der Amide, Ether, Ester, Etherester und/oder Ketone (linear oder cyclisch), enthalten, beispielsweise Butyrolacton (4-Hydroxybuttersäurelacton). Dies kann mit einem Gehalt von 1 bis 30 Gew.% in der Entschichtungsflüssigkeit vorliegen.

Zur Stabilisierung des Oxidationsmittels empfiehlt sich die Zugabe von vorzugsweise konzentrierter Schwefelsäure und/oder Salpetersäure mit einem Gehalt von mindestens 0,1 bis höchstens 5 Gew.%, bezogen auf die Entschichtungsflüssigkeit. Es versteht sich, daß die Höchstwerte für die einzelnen Bestandteile der Entschichtungsflüssigkeit jeweils nur so hoch sein können, daß die Addition der einzelnen Bestandteile nicht mehr als 100 Gew.% ergibt.

Der zweite Teil der Aufgabe wird erfindungsgemäß durch eine Entschichtungsflüssigkeit zum Entfernen von Schablonenmaterial von einem Siebdruckschablonenträger gelöst, die vorbeschriebene Zusammensetzung hat. Zusätzlich kann die Entschichtungsflüssigkeit auch noch mit Farbstoffen oder Pigmenten versehen sein. üblicherweise sind ergänzend noch Additive, wie Dispergierhilfsstoffe, Komplexbildner und/oder Entschäumer enthalten. Insoweit kann auf die Erfahrungen mit den bekannten Entschichtungsflüssigkeiten zurückgegriffen werden. Die Anwendung der Entschichtungsflüssigkeit wie auch des Hydrophilierungsmittels kann sowohl manuell als auch maschinell erfolgen.

Nachfolgend sind die üblichen Zusammensetzungen sowohl des Hydrophilierungsmittels als auch der Entschichtungsflüssigkeit mit Bereichsangaben für die einzelnen Bestandteile angegeben. Innerhalb der angegebenen Bereiche kommen jeweils nur solche werte in Frage, die in der Summe der Bestandteile 100 Gew.% ergeben.

| **Hydrophilierungsmittel** | |
|---|---|
| 0,01 - 50 Gew.% | nichtionisches Tensid auf Basis Fettalkoholpolyalkylenglycolether (z.B. das Produkt "Propetal 99" der Zschimmer & Schwarz GmbH & Co., D-56112 Lahnstein/ Rhein) |
| 0,15 - 29,7 Gew.% | feinstteilige Oxide, z.B. Zirkonoxid oder Aluminiumoxid |
| Rest | Wasser |

| **Entschichtungsmittel** | | |
|---|---|---|
| 1. | 0,1 - 5 % | Natriummetaperiodat |
| | 0,05 - 5 % | konzentrierte Salpetersäure |
| | 0,01 - 50 % | nichtionisches Tensid (z.B. das Produkt "Propetal 99" der Zschimmer & Schwarz GmbH & Co., D-56112 Lahnstein/Rhein) |
| | 0,15 - 27 % | Oxid, z.B. Zirkonoxid oder Alumini umoxid |
| | Rest | Wasser |
| 2. | 0,1 - 5 % | Natriummetaperiodat |
| | 0,05 - 5 % | konzentrierte Salpetersäure |
| | 0,01 - 50 % | nichtionisches Tensid (z.B. das Produkt "Propetal 99" der Zschimmer & Schwarz GmbH & Co., D-56112 Lahnstein/Rhein) |
| | 0,15 - 27 % | oxid, z.B. Zirkonoxid oder Aluminiumoxid |
| | 1 - 30 % | organisches Lösemittel, z.B. Butyrolacton |
| | Rest | Wasser |

Die nachstehende Tabelle gibt die Wirksamkeit des erfindungsgemäßen Hydrophilierungsmittel und der erfindungsgemäßen Entschichtungsflüssigkeit im Vergleich zu bekannten Mitteln wieder. Dabei wurde jeweils ein Siebdruckgewebe mit einer Maschenweite von 34 µm mit den unten angegebenen Substanzen behandelt. Die Behandlung wurde wie folgt durchgeführt.

Das Hydrophilierungsmittel bzw. Entfettungsmittel wurde aufgesprüht und mit einer Bürste gleichmäßig verteilt. Nach kurzer Verweilzeit auf dem Siebdruckgewebe wurde es mit einer üblichen Handbrause mit Wasser abgespült und getrocknet. Dann wurde der Kontaktwinkel gegen Wasser gemessen, und das Siebdruckgewebe wurde anschließend mit einer handelsüblichen Fotoemulsion (Schablonenmaterial) beschichtet. Die resultierende Oberflächengüte wurde visuell beurteilt.

Für die Beurteilung der Entschichtungsflüssigkeit wurde das unbehandelte Siebdruckgewebe mit einer handelsüblichen Fotoemulsion (Schablonenmaterial) beschichtet, belichtet und getrocknet. Anschließend wurde die Entschichtungsflüssigkeit mit einer Bürste gleichmäßig über die Schablone verteilt und die damit oxidativ angelöste Schablone mit einem handelsüblichen Hochdruckgerät entfernt. Nach der Trocknung des Siebdruckgewebes wurde der Kontaktwinkel gegen Wasser gemessen und anschließend das Siebdruckgewebe wieder mit der gleichen Fotoemulsion beschichtet. Die resultierende Oberflächengüte der so gebildeten Schablone wurde visuell beurteilt.

| **Hydrophilierungsmittel** | | |
|---|---|---|
| **Angabe jeweils in Gew.%** | | **Kontaktwinkel (°)gegen Wasser** |
| **Beispiel 1** | | 50 - 60 |
| (Hydrophilierungsmittel) | | |
| 1 | Propetal 99 | |
| 3 | Zirkonoxid | |
| 96 | Wasser | |
| **Beispiel 2** | | 40 - 50 |
| (Hydrophilierungsmittel) | | |
| 1 | Propetal 99 | |
| 0,3 | Aluminiumoxid | |
| 98,7 | Wasser | |
| **Beispiel 3** | | 35 - 40 |
| (Hydrophilierungsmittel) | | |
| 1 | Propetal 99 | |
| 9 | Aluminiumoxid | |
| 90 | Wasser | |
| **Beispiel 4** | | 30 - 35 |
| (Hydrophilierungsmittel) | | |
| 1 | Propetal 99 | |
| 29,7 | Aluminiumoxid | |
| 69,3 | wasser | |
| **Vergleichsbeispiel 1** | | 90 - 100 |
| (unbehandeltes Gewebe) | | |
| **Vergleichsbeispiel 2** | | 80 - 90 |
| (Entfettungsmittel) | | |
| 1 | Propetal 99 | |
| 99 | Wasser | |

| **Entschichtungeflüssigkeit** | | |
|---|---|---|
| **Angabe jeweils in Gew.% %** | | **Kontaktwinkel (°)gegen Wasser** |
| **Beispiel 5** | | |
| (Entschichtungsflüssigkeit) | | 50 - 55 |
| 0,5 | Natriummetaperiodat | |
| 0,05 | konzentrierte | |
| | Salpetersäure | |
| 1 | Propetal 99 | |
| 3 | Aluminiumoxid | |
| 95,45 | Wasser | |
| **Beispiel 6** | | 55 - 60 |
| (Entschichtungsflüssigkeit mit | | |
| Reinigung) | | |
| 0,5 | Natriummetaperiodat | |
| 0,05 | konzentrierte | |
| | Salpetersäure | |
| 1 | Propetal 99 | |
| 3 | Aluminiumoxid | |
| 10 | Butyrolacton | |
| 85,45 | Wasser | |
| **Vergleichsbeispiel 3** | | 90 - 100 |
| 0,5 | Natriummetaperiod | |
| 0,05 | konzentrierte | |
| | Salpetersäure | |
| 1 | Propetal 99 | |
| 98,45 | Wasser | |

Aus der vorstehenden Tabelle wird deutlich, daß mit dem herkömmlichen Entfettungsmittel (vergleichsbeispiel 2) wie auch mit der bekannten Entschichtungsflüssigkeit keine signifikante Reduzierung des Kontaktwinkels gegen Wasser erreicht werden kann, so daß die Benetzungsfähigkeit des Siebdruckgewebes sich praktisch nicht von der eines unbehandelten Siebdruckgewebes (vergleichsbeispiel 1) unterscheidet. Erst durch die Verwendung des erfindungsgemäßen Hydrophilierungsmittels oder der erfindungsgemäßen Entschichtungsflüssigkeit auf der Basis feinstteiliger Oxide wird eine deutliche Hydrophilierung des Siebdruckgewebes erreicht, wie die Beispiele 1 bis 6 zeigen. Eine anschließende (Wieder)Beschichtung des Siebdruckgewebes mit Schablonenmaterial zeigt den gewünschten Effekt. Aufgrund des wesentlich besseren Benetzungsverhaltens waren Fehlstellen kaum oder gar nicht visuell erkennbar. Die Oberfläche der Schablone war visuell deutlich gleichmäßiger als bei Verwendung der Substanzen gemäß den Vergleichsbeispielen.

## Patentansprüche

1. Verfahren zur Hydrophilierung von Siebdruckschablonenträgern ohne Schablonenmaterial, bei dem der Siebdruckschablonenträger mit einem Hydrophilierungsmittel behandelt wird, **dadurch gekennzeichnet, daß** ein Hydrophilierungsmittel verwendet wird, das feinstteilige Aluminium- und/oder Zirkonium-Oxidteilchen mit einer im Nanometerbereich liegende Teilchengröße und ein Benetzungsmittel enthält.

2. Verfahren nach Anspruch 1, **dadurch gekennzeichnet, daß** die Teilchengröße der Oxidteilchen bei 2 bis 40 nm liegt.

3. Verfahren nach Anspruch 1 oder 2, **dadurch gekennzeichnet, daß** die Oxidteilchen mit Ionen aus der Gruppe der Alkali- bzw. Erdalkaliionen und/oder mit anorganischen oder organischen Salzen modifiziert sind, welche in Verbindungen mit Aluminium, Zirkonium, Zink oder Titan vorliegen.

4. Verfahren nach einem der Ansprüche 1 bis 3, **dadurch gekennzeichnet, daß** die Oxidteilchen **dadurch** funktionalisiert sind, daß funktionelle Gruppen der organischen Seitenketten Epoxid-, Acryloxy-, Methacryloxy-, Glycidiloxy-, Alkyl-, Vinyl-, Carboxyl-, Mercapto-, Hydroxyl-, Amid-, Amino-, Isocyano- oder Silanolgruppen eingefügt sind.

5. Verfahren nach einem der Ansprüche 1 bis 4, **dadurch gekennzeichnet, daß** die Oxidteilchen in dem Hydrophilierungsmittel mit einem Anteil von 0,15 bis 29,7 Gew.% vorhanden sind.

6. Verfahren nach einem der vorherigen Ansprüche 1 bis 5, **dadurch gekennzeichnet, daß** das Benetzungsmittel ein Tensid, insbesondere ein nichtionisches Tensid, ist.

7. Verfahren nach Anspruch 6, **dadurch gekennzeichnet, daß** das nichtionische Tensid ein Ethoxylat oder Alkoxylat von primären und sekundären Fettalkoholen oder von Alkylphenolen, ein Ethylenoxid/Propylenoxid- oder Propylenoxid/Ethylenoxid-Blockpolimerisat, ein Aminethoxylat, Aminalkoxylat, ein Alkylpolyglycolid, ein Fettaminoxid, ein Fettsäurealkanolamid und/oder ein Fettsäurealkylglucamid ist.

8. Verfahren nach Anspruch 6, **dadurch gekennzeichnet, daß** das Tensid ein endgruppenverschlossenes Tensid ist, bei dem die Hydroxylgruppe mit einer Alkylgruppe verethert ist.

9. verfahren nach einem der Ansprüche 1 bis 8, **dadurch gekennzeichnet, daß** das Benetzungsmittel in dem Hydrophilierungsmittel mit einem Gehalt von 0,01 bis 20 Gew.% vorhanden ist.

10. Verfahren zur Entfernung von Schablonenmaterial von einem Siebdruckschablonenträger, indem auf den Siebdruckschablonenträger bzw. das Schablonenmaterial eine Entschichtungsflüssigkeit aufgebracht wird, die ein Entschichtungsmittel und ein Benetzungsmittel enthält, **dadurch gekennzeichnet, daß** eine Entschichtungsflüssigkeit verwendet wird, die zusätzlich feinstteilige Aluminium- und/oder zirkonium-Oxidteilchen mit einer im Nanometerbereich liegende Teilchengröße enthält.

11. Verfahren nach Anspruch 10, **dadurch gekennzeichnet, daß** die Teilchengröße der Oxidteilchen bei 2 bis 40 nm liegt.

12. Verfahren nach Anspruch 10 oder 11, **dadurch gekennzeichnet, daß** die Oxidteilchen mit Ionen aus der Gruppe der Alkali- bzw. Erdalkaliionen und/oder mit anorganischen oder organischen Salzen modifiziert sind, welche in Verbindungen mit Aluminium, zirkonium, Zink oder Titan vorliegen.

13. Verfahren nach einem der Ansprüche 10 bis 12, **dadurch gekennzeichnet, daß** die Oxidteilchen **dadurch** funktionalisiert sind, daß funktionelle Gruppen der organischen Seitenketten Epoxid-, Acryloxy-, Methacryloxy-, Glycidiloxy-, Alkyl-, vinyl-, Carboxyl-, Mercapto-, Hydroxyl-, Amid-, Amino-, Isocyano- oder Silanolgruppen eingefügt sind.

14. Verfahren nach einem der Ansprüche 10 bis 13, **dadurch gekennzeichnet, daß** die Oxidteilchen in der Entschichtungsflüssigkeit mit einem Anteil von 0,15 bis 27 Gew.% vorhanden sind.

15. Verfahren nach einem der Ansprüche 10 bis 14, **dadurch gekennzeichnet, daß** das Benetzungsmittel ein Tensid, insbesondere ein nichtionisches Tensid, ist.

16. Verfahren nach Anspruch 15, **dadurch gekennzeichnet, daß** das nichtionische Tensid ein Ethoxylat oder Alkoxylat von primären und sekundären Fettalkoholen oder von Alkylphenolen, ein Ethylenoxid/Propylenoxid- oder Propylenoxid/Ethylenoxid-Blockpolimerisat, ein Aminethoxylat, Aminalkoxylat, ein Alkylpolyglycolid, ein Fettaminoxid, ein Fettsäurealkanolamid und/oder ein Fettsäurealkylglucamid ist.

17. Verfahren nach Anspruch 15, **dadurch gekennzeichnet, daß** das Tensid ein endgruppenverschlossenes Tensid ist, bei dem die Hydroxylgruppe mit einer Alkylgruppe verethert ist.

18. Verfahren nach einem der Ansprüche 10 bis 17, **dadurch gekennzeichnet, daß** das Benetzungsmittel in der Entschichtungsflüssigkeit mit einem Gehalt von 0,01 bis 20 Gew.% vorhanden ist.

19. Verfahren nach einem der Ansprüche 10 bis 18, **dadurch gekennzeichnet, daß** das Entschichtungsmittel ein Oxidationsmittel enthält.

20. Verfahren nach Anspruch 19, **dadurch gekennzeichnet, daß** das Oxidationsmittel zumindest ein Iodat, insbesondere Periodat und/oder eine Periodsäure, ist.

21. verfahren nach Anspruch 19 oder 20, **dadurch gekennzeichnet, daß** das Oxidationsmittel ein Natriumperiodat, insbesondere Natriummetaperiodat, ist.

22. Verfahren nach einem der Ansprüche 19 bis 21, **dadurch gekennzeichnet, daß** das Oxidationsmittel in der Entschichtungsflüssigkeit mit einem Gehalt von 0,1 bis 5 Gew.% vorhanden ist.

23. Verfahren nach einem der Ansprüche 10 bis 22, **dadurch gekennzeichnet, daß** die Entschichtungsflüssigkeit zusätzlich ein organische Lösungsmittel enthält.

24. Verfahren nach Anspruch 23, **dadurch gekennzeichnet, daß** das organische Lösungsmittel aus der Gruppe der Amide, Ether, Ester, Etherester und/oder Ketone (linear oder cyclisch) ausgewählt ist.

25. Verfahren nach Anspruch 23 oder 24, **dadurch gekennzeichnet, daß** das Lösungsmittel Butyrolacton ist.

26. Verfahren nach einem der Ansprüche 23 bis 25, **dadurch gekennzeichnet, daß** das Lösungsmittel in der Entschichtungsflüssigkeit mit einem Gehalt von 1 bis 30 Gew.% vorliegt.

27. Verfahren nach einem der Ansprüche 10 bis 26, **dadurch gekennzeichnet, daß** die Entschichtungsflüssigkeit Schwefelsäure und/oder Salpetersäure enthält.

28. Verfahren nach Anspruch 29, **dadurch gekennzeichnet, daß** Schwefelsäure und/oder Salpetersäure in der Entschichtungsflüssigkeit mit einem Gehalt von 0,1 bis 5 Gew.% vorhanden ist.

29. Entschichtungsflüssigkeit zum Entfernen von Schablonenmaterial von einem Siebdruckschablonenträger mit einem Entschichtungsmittel und einem Benetzungsmittel, **dadurch gekennzeichnet, daß** die Entschichtungsflüssigkeit feinstteilige Aluminium- und/oder zirkonium-Oxidteilchen mit einer im Nanometerbereich liegende Teilchengröße enthält.

30. Entschichtungsflüssigkeit nach Anspruch 29, **dadurch gekennzeichnet, daß** die Teilchengröße der Oxidteilchen bei 2 bis 40 nm liegt.

31. Entschichtungsflüssigkeit nach Anspruch 29 oder 30, **dadurch gekennzeichnet, daß** die Oxidteilchen mit Ionen aus der Gruppe der Alkali- bzw. Erdalkaliionen und/oder mit anorganischen oder organischen Salzen modifiziert sind, welche in Verbindungen mit Aluminium, Zirkonium, Zink oder Titan vorliegen.

32. Entschichtungsflüssigkeit nach einem der Ansprüche 29 bis 31, **dadurch gekennzeichnet, daß** die Oxidteilchen **dadurch** funktionalisiert sind, daß funktionelle Gruppen der organischen Seitenketten Epoxid-, Acryloxy-, Methacryloxy-, Glycidiloxy-, Alkyl-, vinyl-, Carboxyl-, Mercapto-, Hydroxyl-, Amid-, Amino-, Isocyano- oder Silanolgruppen eingefügt sind.

33. Entschichtungsflüssigkeit nach einem der Ansprüche 29 bis 32, **dadurch gekennzeichnet, daß** die Oxidteilchen in der Entschichtungsflüssigkeit mit einem Anteil von 0,15 bis 27 Gew.% vorhanden sind.

34. Entschichtungsflüssigkeit nach einem der Ansprüche 29 bis 33, **dadurch gekennzeichnet, daß** das Benetzungsmittel ein Tensid, insbesondere ein nichtionisches Tensid, ist.

35. Entschichtungsflüssigkeit nach Anspruch 34, **dadurch gekennzeichnet, daß** das nichtionische Tensid ein Ethoxylat oder Alkoxylat von primären und sekundären Fettalkoholen oder von Alkylphenolen, ein Ethylenoxid/Propylenoxid- oder Propylenoxid/Ethylenoxid-Blockpolimerisat, ein Aminethoxylat, Aminalkoxylat, ein Alkylpolyglycolid, ein Fettaminoxid, ein Fettsäurealkanolamid und/oder ein Fettsäurealkylglucamid ist.

36. Entschichtungsflüssigkeit nach Anspruch 34, **dadurch gekennzeichnet, daß** das Tensid ein endgruppenverschlossenes Tensid ist, bei dem die Hydroxylgruppe mit einer Alkylgruppe verethert ist.

37. Entschichtungsflüssigkeit nach einem der Ansprüche 29 bis 36, **dadurch gekennzeichnet, daß** das Benetzungsmittel in der Entschichtungsflüssigkeit mit einem Gehalt von 0,01 bis 20 Gew.% vorhanden ist.

38. Entschichtungsflüssigkeit nach einem der Ansprüche 29 bis 37, **dadurch gekennzeichnet, daß** das Entschichtungsmittel ein Oxidationsmtitel enthält.

39. Entschichtungsflüssigkeit nach Anspruch 38, **dadurch gekennzeichnet, daß** das Oxidationsmittel zumindest ein Iodat, insbesondere Periodat und/oder eine Periodsäure, ist.

40. Entschichtungsflüssigkeit nach Anspruch 38 oder 39, **dadurch gekennzeichnet, daß** das Oxidationsmittel ein Natriumperiodat, insbesondere Natriummetaperiodat, ist.

41. Entschichtungsflüssigkeit nach einem der Ansprüche 38 bis 40, **dadurch gekennzeichnet, daß** das Oxidationsmittel in der Entschichtungsflüssigkeit mit einem Gehalt von 0,1 bis 5 Gew.% vorhanden ist.

42. Entschichtungsflüssigkeit nach einem der Ansprüche 29 bis 41, **dadurch gekennzeichnet, daß** die Entschichtungsflüssigkeit zusätzlich ein organische Lösungsmittel enthält.

43. Entschichtungsflüssigkeit nach Anspruch 42, **dadurch gekennzeichnet, daß** das organische Lösungsmittel aus der Gruppe der Amide, Ether, Ester, Etherester und/oder Ketone (linear oder cyclisch) ausgewählt ist.

44. Entschichtungsflüssigkeit nach Anspruch 42 oder 43, **dadurch gekennzeichnet, daß** das Lösungsmittel Butyrolacton ist.

45. Entschichtungsflüssigkeit nach einem der Ansprüche 42 bis 44, **dadurch gekennzeichnet, daß** das Lösungsmittel in der Entschichtungsflüssigkeit mit einem Gehalt von 1 bis 30 Gew.% vorliegt.

46. Entschichtungsflüssigkeit nach einem der Ansprüche 29, bis 45, **dadurch gekennzeichnet, daß** die Entschichtungsflüssigkeit Schwefelsäure und/oder Salpetersäure enthält.

47. Entschichtungsflüssigkeit nach Anspruch 46, **dadurch gekennzeichnet, daß** Schwefelsäure und/oder Salpetersäure in der Entschichtungsflüssigkeit mit einem Gehalt von 0,1 bis 5 Gew.% vorhanden ist.

## Claims

1. A method for hydrophilizing screen printing stencil carriers without stencil material, in which the screen printing stencil carrier is treated with a hydrophilizing agent, **characterized in that** a hydrophilizing agent containing ultra-fine aluminum and/or zirconium oxide particles having a particle size in the nanometer range, and a wetting agent is used.

2. The method according to Claim 1, **characterized in that** the particle size of the oxide particles is from 2 to 40 nm.

3. The method according to Claim 1 or 2, **characterized in that** the oxide particles are modified with ions from the group of the alkaline or alkaline-earth ions and/ or with inorganic or organic salts that are present in compounds with aluminum, zirconium, zinc, or titanium.

4. The method according to any of Claims 1 to 3, **characterized in that** the oxide particles are functionalized by the fact that functional groups of the organic side chains of epoxy, acryloxy, methacryloxy, glycidyloxy, alkyl, vinyl, carboxyl, mercapto, hydroxyl, amide, amino, isocyano, or silanol groups are inserted.

5. The method according to any of Claims 1 to 4, **characterized in that** the oxide particles are present in the hydrophilizing agent in a proportion from 0.15 to 29.7 wt%.

6. The method according to any of the foregoing Claims 1 to 5, **characterized in that** the wetting agent is a surfactant, in particular a nonionic surfactant.

7. The method according to Claim 6, **characterized in that** the nonionic surfactant is an ethoxylate or alkoxylate of primary and secondary fatty alcohols or of alkylphenols, an ethylene oxide/propylene oxide or propylene oxide/ethylene oxide block polymer, an aminoethoxylate, an aminoalkoxylate, an alkylpolyglycolide, a fatty amine oxide, a fatty acid alkanolamide, and/or a fatty acid alkylglucamide.

8. The method according to Claim 6, **characterized in that** the surfactant is an end-capped surfactant in which the hydroxyl group is etherified with an alkyl group.

9. The method according to any of Claims 1 to 8, **characterized in that** the wetting agent is present in the hydrophilizing agent at a concentration from 0.01 to 20 wt%.

10. A method for removing stencil material from a screen printing stencil carrier, in which a coating-removal fluid that contains a coating-removal agent and a wetting agent is applied onto the screen printing stencil carrier and onto the stencil material, **characterized in that** a coating-removal fluid that additionally contains ultra-fine aluminum and/or zirkonium oxide particles having a particle size in the nanometer range is used.

11. The method according to Claim 10, **characterized in that** the particle size of the oxide particles is from 2 to 40 nm.

12. The method according to Claim 11 or 11, **characterized in that** the oxide particles are modified with ions from the group of the alkaline or alkaline-earth ions and/or with inorganic or organic salts that are present in compounds with aluminum, zirconium, zinc, or titanium.

13. The method according to any of Claims 10 to 12, **characterized in that** the oxide particles are functionalized by the fact that functional groups of the organic side chains [of] epoxy, acryloxy, methacryloxy, glycidyloxy, alkyl, vinyl, carboxyl, mercapto, hydroxyl, amide, amino, isocyano, or silanol groups are inserted.

14. The method according to any of Claims 10 to 13, **characterized in that** the oxide particles are present in the coating-removal fluid in a proportion from 0.15 to 27 wt%.

15. The method according to any of the Claims 10 to 14, **characterized in that** the wetting agent is a surfactant, in particular a nonionic surfactant.

16. The method according to Claim 15, **characterized in that** the nonionic surfactant is an ethoxylate or alkoxylate of primary and secondary fatty alcohols or of alkylphenols, an ethylene oxide/propylene oxide or propylene oxide/ethylene oxide block polymer, an aminoethoxylate, an aminoalkoxylate, an alkylpolyglycolide, a fatty amine oxide, a fatty acid alkanolamide, and/ or a fatty acid alkylglucamide.

17. The method according to Claim 15, **characterized in that** the surfactant is an end-capped surfactant in which the hydroxyl group is etherified with an alkyl group.

18. The method according to any of Claims 10 to 17, **characterized in that** the wetting agent is present in the coating-removal fluid at a concentration from 0.01 to 20 wt%.

19. The method according to any of Claims 10 to 18, **characterized in that** the coating-removal agent contains an oxidizing agent.

20. The method according to Claim 19, **characterized in that** the oxidizing agent is at least one iodate, in particular a periodate, and/or a periodic acid.

21. The method according to Claim 19 or 20, **characterized in that** the oxidizing agent is a sodium periodate, in particular sodium metaperiodate.

22. The method according to any of Claims 19 to 21, **characterized in that** the oxidizing agent is present in the coating-removal fluid at a concentration from 0.1 to 5 wt%.

23. The method according to any of Claims 10 to 22, **characterized in that** the coating-removal fluid additionally contains an organic solvent.

24. The method according to Claim 23, **characterized in that** the organic solvent is selected from the group of the amides, ethers, esters, ether esters, and/or ketones (linear or cyclic).

25. The method according to Claim 23 or 24, **characterized in that** the solvent is butyrolactone.

26. The method according to any of Claims 23 to 25, **characterized in that** the solvent is present in the coating-removal fluid at a concentration from 1 to 30 wt%.

27. The method according to any of Claims 10 to 26, **characterized in that** the coating-removal fluid contains sulfuric acid and/ or nitric acid.

28. The method according to Claim 27, **characterized in that** the sulfuric acid and/or nitric acid is present in the coating-removal fluid at a concentration from 0.1 to 5 wt%.

29. A coating-removal fluid, having a coating-removal agent and a wetting agent, for the removal of stencil material from a screen printing stencil carrier, **characterized in that** the coating-removal fluid contains ultra-fine aluminum and/ or zirkonium oxide particles having a particle size in the nanometer range.

30. The coating-removal fluid according to Claim 29, **characterized in that** the particle size of the oxide particles is from 2 to 40 nm.

31. The coating-removal fluid according to Claim 29 or 30, **characterized in that** the oxide particles are modified with ions from the group of the alkaline or alkaline-earth ions and/or with inorganic or organic salts that are present in compounds with aluminum, zirconium, zinc, or titanium.

32. The coating-removal fluid according to any of Claims 29 to 31, **characterized in that** the oxide particles are functionalized by the fact that functional groups of the organic side chains of epoxy, acryloxy, methacryloxy, glycidyloxy, alkyl, vinyl, carboxyl, mercapto, hydroxyl, amide, amino, isocyano, or silanol groups are inserted.

33. The coating-removal fluid according to any of Claims 29 to 32, **characterized in that** the oxide particles are present in the coating-removal fluid in a proportion from 0.15 to 27 wt%.

34. The coating-removal fluid according to any of Claims 29 to 33, **characterized in that** the wetting agent is a surfactant, in particular a nonionic surfactant.

35. The coating-removal fluid according to Claim 34, **characterized in that** the nonionic surfactant is an ethoxylate or alkoxylate of primary and secondary fatty alcohols or of alkylphenols, an ethylene oxide/propylene oxide or propylene oxide/ethylene oxide block polymer, an aminoethoxylate, an aminoalkoxylate, an alkylpolyglycolide, a fatty amine oxide, a fatty acid alkanolamide, and/or a fatty acid alkylglucamide.

36. The coating-removal fluid according to Claim 34, **characterized in that** the surfactant is an end-capped surfactant in which the hydroxyl group is etherified with an alkyl group.

37. The coating-removal fluid according to any of Claims 29 to 36, **characterized in that** the wetting agent is present in the coating-removal fluid at a concentration from 0.01 to 20 wt%.

38. The coating-removal fluid according to any of Claims 29 to 37, **characterized in that** the coating-removal agent contains an oxidizing agent.

39. The coating-removal fluid according to Claim 38, **characterized in that** the oxidizing agent is at least one iodate, in particular a periodate, and/or a periodic acid.

40. The coating-removal fluid according to Claim 38 or 39, **characterized in that** the oxidizing agent is a sodium periodate, in particular sodium metaperiodate.

41. The coating-removal fluid according to any of Claims 38 to 40, **characterized in that** the oxidizing agent is present in the coating-removal fluid at a concentration from 0.1 to 5 wt%.

42. The coating-removal fluid according to any of Claims 29 to 41, **characterized in that** the coating-removal fluid additionally contains an organic solvent.

43. The coating-removal fluid according to Claim 42, **characterized in that** the organic solvent is selected from the group of the amides, ethers, esters, ether esters, and/or ketones (linear or cyclic).

44. The coating-removal fluid according to Claim 42 or 43, **characterized in that** the solvent is butyrolactone.

45. The coating-removal fluid according to any of Claims 42 to 44, **characterized in that** the solvent is present in the coating-removal fluid at a concentration from 1 to 30 wt%.

46. The coating-removal fluid according to any of Claims 29 to 45, **characterized in that** the coating-removal fluid contains sulfuric acid and/ or nitric acid.

47. The coating-removal fluid according to Claim 46, **characterized in that** the sulfuric acid and/or nitric acid is present in the coating-removal fluid at a concentration from 0.1 to 5 wt%.

## Revendications

1. Procédé d'hydrophilisation de supports d'écran de soie pour sérigraphie sans matériau d'écran, dans lequel le support d'écran de soie pour sérigraphie est traité avec un agent d'hydrophilisation, **caractérisé en ce que** l'on utilise un agent d'hydrophilisation, qui contient des particules très finement divisées d'oxyde d'aluminium et/ou de zirconium, avec une granulométrie se situant dans la gamme ou le domaine nanométrique et un agent mouillant.

2. Procédé selon la revendication 1, **caractérisé en ce que** la granulométrie des particules d'oxyde se situe dans l'intervalle allant de 2 à 40 nm.

3. Procédé selon la revendication 1 ou 2, **caractérisé en ce que** les particules d'oxyde sont modifiées avec des ions du groupe des ions alcalins et respectivement, alcalino-terreux et/ou avec des sels inorganiques ou organiques, lesquels se présentent dans des composés avec de l'aluminium, du zirconium, du zinc ou du titane.

4. Procédé selon l'une des revendications 1 à 3, **caractérisé en ce que** les particules d'oxyde sont fonctionnalisées **en ce que** des groupes fonctionnels sont ajoutés ou insérés sur les chaînes latérales organiques, des groupes époxyde, acryloxy, méthacryloxy, glycidyloxy, alkyle, vinyle, carboxyle, mercapto, hydroxyle, amide, amino, isocyano ou silanol.

5. Procédé selon l'une des revendications 1 à 4, **caractérisé en ce que** les particules d'oxyde sont présentes dans l'agent d'hydrophilisation en une proportion allant de 0,15 à 29,7 % en poids.

6. Procédé selon l'une des revendications 1 à 5, **caractérisé en ce que** l'agent mouillant est un tensioactif, en particulier un tensioactif non ionique.

7. Procédé selon la revendication 6, **caractérisé en ce que** le tensioactif non ionique est un éthoxylate ou alcoxylate d'alcools gras primaires et secondaires ou d'alkylphénols, un polymère séquencé d'oxyde d'éthylène/oxyde de propylène ou d'oxyde de propylène/oxyde d'éthylène, un aminoéthoxylate, un aminoalcoxylate, un alkylpolyglycolide, un oxyde d'amine grasse, un alcanolamide d'acide gras et/ou un aklylglucamide d'acide gras.

8. Procédé selon la revendication 6, **caractérisé en ce que** le tensioactif est un tensioactif à groupe terminal coiffé, dans lequel le groupe hydroxyle est éthérifié avec un groupe alkyle.

9. Procédé selon l'une des revendications 1 à 8, **caractérisé en ce que** l'agent mouillant est présent dans l'agent d'hydrophilisation avec une teneur allant de 0,01 à 20 % en poids.

10. Procédé d'élimination du matériau d'écran d'un support d'écran de soie pour sérigraphie, en ce que sur le support d'écran de soie pour sérigraphie et respectivement, le matériau d'écran, est appliqué un liquide d'enlèvement d'une couche, qui contient un agent d'enlèvement d'une couche et un agent mouillant, **caractérisé en ce que** l'on utilise un liquide d'enlèvement d'une couche, qui contient en outre, des particules très finement divisées d'oxyde d'aluminium et/ou de zirconium, avec une granulométrie se situant dans la gamme ou le domaine nanométrique.

11. Procédé selon la revendication 10, **caractérisé en ce que** la granulométrie des particules d'oxyde se situe dans l'intervalle allant de 2 à 40 nm.

12. Procédé selon la revendication 10 ou 11, **caractérisé en ce que** les particules d'oxyde sont modifiées avec des ions du groupe des ions alcalins et respectivement, alcalino-terreux et/ou avec des sels inorganiques ou organiques, lesquels se présentent dans des composés avec de l'aluminium, du zirconium, du zinc ou du titane.

13. Procédé selon l'une des revendications 10 à 12, **caractérisé en ce que** les particules d'oxyde sont fonctionnalisées **en ce que** des groupes fonctionnels sont ajoutés ou insérés sur les chaînes latérales organiques, des groupes époxyde, acryloxy, méthacryloxy, glycidyloxy, alkyle, vinyle, carboxyle, mercapto, hydroxyle, amide, amino, isocyano ou silanol.

14. Procédé selon l'une des revendications 10 à 13, **caractérisé en ce que** les particules d'oxyde sont présentes dans l'agent d'enlèvement d'une couche en une proportion allant de 0,15 à 27 % en poids.

15. Procédé selon l'une des revendications 10 à 14, **caractérisé en ce que** l'agent mouillant est un tensioactif, en particulier un tensioactif non ionique.

16. Procédé selon la revendication 15, **caractérisé en ce que** le tensioactif non ionique est un éthoxylate ou alcoxylate d'alcools gras primaires et secondaires ou d'alkylphénols, un polymère séquencé d'oxyde d'éthylène/oxyde de propylène ou d'oxyde de propylène/oxyde d'éthylène, un aminoéthoxylate, un aminoalcoxylate, un alkylpolyglycolide, un oxyde d'amine grasse, un alcanolamide d'acide gras et/ou un aklylglucamide d'acide gras.

17. Procédé selon la revendication 15, **caractérisé en ce que** le tensioactif est un tensioactif à groupe terminal coiffé, dans lequel le groupe hydroxyle est éthérifié avec un groupe alkyle.

18. Procédé selon l'une des revendications 10 à 17, **caractérisé en ce que** l'agent mouillant est présent dans le liquide d'enlèvement d'une couche avec une teneur allant de 0,01 à 20 % en poids.

19. Procédé selon l'une des revendications 10 à 18, **caractérisé en ce que** l'agent d'enlèvement d'une couche contient un agent oxydant.

20. Procédé selon la revendication 19, **caractérisé en ce que** l'agent oxydant est au moins un iodate, en particulier un periodate et/ou un acide periodique.

21. Procédé selon la revendication 19 ou 20, **caractérisé en ce que** l'agent oxydant est un periodate de sodium, en particulier le métaperiodate de sodium.

22. Procédé selon l'une des revendications 19 à 21, **caractérisé en ce que** l'agent d'oxydation est présent dans le liquide d'enlèvement d'une couche avec une teneur allant de 0,1 à 5 % en poids.

23. Procédé selon l'une des revendications 10 à 22, **caractérisé en ce que** le liquide d'enlèvement d'une couche contient en outre, un solvant organique.

24. Procédé selon la revendication 23, **caractérisé en ce que** le solvant organique est choisi parmi le groupe des amides, des éthers, des esters, des éther-esters et/ou des cétones (linéaires ou cycliques).

25. Procédé selon la revendication 23 ou 24, **caractérisé en ce que** le solvant est la butyrolactone.

26. Procédé selon l'une des revendications 23 à 25, **caractérisé en ce que** le solvant est présent dans le liquide d'enlèvement d'une couche avec une teneur allant de 1 à 30 % en poids.

27. Procédé selon l'une des revendications 10 à 26, **caractérisé en ce que** le liquide d'enlèvement d'une couche contient de l'acide sulfurique et/ou de l'acide nitrique.

28. Procédé selon la revendication 29, **caractérisé en ce que** l'acide sulfurique et/ou l'acide nitrique est présent dans le liquide d'enlèvement d'une couche avec une teneur allant de 0,1 à 5 % en poids.

29. Liquide d'enlèvement d'une couche pour l'élimination du matériau d'écran d'un support d'écran de soie pour sérigraphie avec un agent d'enlèvement d'une couche et un agent mouillant, **caractérisé en ce que** le liquide d'enlèvement d'une couche contient des particules très finement divisées d'oxyde d'aluminium et/ou de zirconium, avec une granulométrie se situant dans la gamme ou le domaine nanométrique.

30. Liquide d'enlèvement d'une couche selon la revendication 29, **caractérisé en ce que** la granulométrie des particules d'oxyde se situe dans l'intervalle allant de 2 à 40 nm.

31. Liquide d'enlèvement d'une couche selon la revendication 29 ou 30, **caractérisé en ce que** les particules d'oxyde sont modifiées avec des ions du groupe des ions alcalins et respectivement, alcalino-terreux et/ou avec des sels inorganiques ou organiques, lesquels se présentent dans des composés avec de l'aluminium, du zirconium, du zinc ou du titane.

32. Liquide d'enlèvement d'une couche selon l'une des revendications 29 à 31, **caractérisé en ce que** les particules d'oxyde sont fonctionnalisées **en ce que** des groupes fonctionnels sont ajoutés ou insérés sur les chaînes latérales organiques, des groupes époxyde, acryloxy, méthacryloxy, glycidyloxy, alkyle, vinyle, carboxyle, mercapto, hydroxyle, amide, amino, isocyano ou silanol.

33. Liquide d'enlèvement d'une couche selon l'une des revendications 29 à 32, **caractérisé en ce que** les particules d'oxyde sont présentes dans l'agent d'enlèvement d'une couche en une proportion allant de 0,15 à 27 % en poids.

34. Liquide d'enlèvement d'une couche selon l'une des revendications 29 à 33, **caractérisé en ce que** l'agent mouillant est un tensioactif, en particulier un tensioactif non ionique.

35. Liquide d'enlèvement d'une couche selon la revendication 34, **caractérisé en ce que** le tensioactif non ionique est un éthoxylate ou alcoxylate d'alcools gras primaires et secondaires ou d'alkylphénols, un polymère séquencé d'oxyde d'éthylène/oxyde de propylène ou d'oxyde de propylène/oxyde d'éthylène, un aminoéthoxylate, un aminoalcoxylate, un alkylpolyglycolide, un oxyde d'amine grasse, un alcanolamide d'acide gras et/ou un aklylglucamide d'acide gras.

36. Liquide d'enlèvement d'une coucher selon la revendication 34, **caractérisé en ce que** le tensioactif est un tensioactif à groupe terminal coiffé, dans lequel le groupe hydroxyle est éthérifié avec un groupe alkyle.

37. Liquide d'enlèvement d'une couche selon l'une des revendications 29 à 36, **caractérisé en ce que** l'agent mouillant est présent dans le liquide d'enlèvement d'une couche avec une teneur allant de 0,01 à 20 % en poids.

38. Liquide d'enlèvement d'une couche selon l'une des revendications 29 à 37, **caractérisé en ce que** l'agent d'enlèvement d'une couche contient un agent oxydant.

39. Liquide d'enlèvement d'une couche selon la revendication 38, **caractérisé en ce que** l'agent oxydant est au moins un iodate, en particulier un periodate et/ou un acide periodique.

40. Liquide d'enlèvement d'une couche selon la revendication 38 ou 39, **caractérisé en ce que** l'agent oxydant est un periodate de sodium, en particulier le métaperiodate de sodium.

41. Liquide d'enlèvement d'une couche selon l'une des revendications 38 à 40, **caractérisé en ce que** l'agent d'oxydation est présent dans le liquide d'enlèvement d'une couche avec une teneur allant de 0,1 à 5 % en poids.

42. Liquide d'enlèvement d'une couche selon l'une des revendications 29 à 41, **caractérisé en ce que** le liquide d'enlèvement d'une couche contient en outre, un solvant organique.

43. Liquide d'enlèvement d'une couche selon la revendication 42, **caractérisé en ce que** le solvant organique est choisi parmi le groupe des amides, des éthers, des esters, des éther-esters et/ou des cétones (linéaires ou cycliques).

44. Liquide d'enlèvement d'une couche selon la revendication 42 ou 43, **caractérisé en ce que** le solvant est la butyrolactone.

45. Liquide d'enlèvement d'une couche selon l'une des revendications 42 à 44, **caractérisé en ce que** le solvant est présent dans le liquide d'enlèvement d'une couche avec une teneur allant de 1 à 30 % en poids.

46. Liquide d'enlèvement d'une couche selon l'une des revendications 29 à 45, **caractérisé en ce que** le liquide d'enlèvement d'une couche contient de l'acide sulfurique et/ou de l'acide nitrique.

47. Liquide d'enlèvement d'une couche selon la revendication 46, **caractérisé en ce que** l'acide sulfurique et/ou l'acide nitrique est présent dans le liquide d'enlèvement d'une couche avec une teneur allant de 0,1 à 5 % en poids.
